# EUROPEAN PATENT APPLICATION

(11) **EP 0 569 076 A1**
(43) Date of publication of application: **10.11.1993**
(21) Application number: 93201174.5
(22) Date of filing: 22.04.1993
(51) Int. Cl.: H01J 37/065, H01J 37/305

(54) **Emitter gun assembly**

(30) Priority: 04.05.1992 US 878132
(71) Applicant: International Business Machines Corporation, Armonk, N.Y. 10504 (US)
(72) Inventor: Carbonne, Quiedo Joseph, Newburgh, New York 12550 (US); Holihan, James Edwin, Wappingers Falls, New York 12590 (US); Poweleit,Helmut Rudolf, Highland, New York 12528 (US); Sliss,Gerald Joseph, Poughkeepsie, New York 12601 (US)
(74) Representative: Louet Feisser, Arnold

(57) **Abstract**

An emitter gun for an electron beam in an evaporation apparatus used in semiconductor processing is improved by: the addition of insulating material that eliminates short circuits caused by the lodging of particles between high voltage electrodes carrying RF voltage and provides for the vaporization of the particles by eddy current heating without damage to the insulator, so that downtime due to short circuits in the emitter gun is eliminated; and by mechanical improvements that increase the gap between the beam former and the anode and that eliminate cracked ceramic insulators.

## Description

The field of the invention is that of integrated circuit fabrication, and particular in the field of performing an electron beam to sputter or otherwise vaporize material in a vacuum chamber.

In the field of chemical vapor deposition, sputtering and other methods of forming integrated circuits, it is often required to heat a target material with an electron beam. The source of electrons for such a beam is known as an emitter gun and consists of a filament to generate the electrons and electrodes to form and direct the electron beam. These emitter guns are susceptible to a number of problems, in particular the formation of short circuits between the high voltage potential and ground caused by particles that are present in the vacuum chamber and by the design of the emitter gun. A particular model that is commonly used in the industry is the series of Temescal models 1800, 2550, 4000, 4800, etc. versions of which nave been on the market for more than twenty years. This tool, which may use emitter guns according to the invention, is used for deposition of thin films of metal and uses an emitter gun to heat the target metal.

The emitter gun in these models is the 270° 4 pocket 67cc electron beam gun used in the 4800 evaporator that when used with any power level is susceptible to short circuits caused by flakes of deposition material moving about loose in the vacuum chamber. When even a small flake was lodged between electrodes, the current pulse caused by the short circuit caused a protective circuit in the power supply to trip, shutting down the tool. These short circuits result in down-time of the tool containing the emitter gun at best and scrapping the work in progress at worst. In the prior art, the mean time between failures of an emitter gun for high power applications has been approximately 2 - 20 hours, which has resulted in a significant amount of down-time for the tool and a significant amount of rework or scrap. When there is a short circuit, the vacuum chamber must be opened to clean and/or replace the emitter gun. In particular, when there is a short circuit during the deposition of Ti, the entire load has to be scrapped because of the formation of oxide on the exposed Ti surface. Workers in the field have been forced to live with this problem for the life of this product and no solution to the problem has been found.

The invention relates to measures taken to improve the reliability of an electron beam gun including insulating critical parts of the apparatus and strengthening other parts of the apparatus.

A feature of the invention is the insulation of gaps between electrodes that are not the narrowest gaps in the emitter.

Another feature of the invention is the lengthening of the anode mounting bracket and the strengthening of the anode.

An embodiment of the invention will be described hereinafter referring to the drawing.

Figure 1 illustrates in perspective an emitter gun according to the invention.

Figure 2 illustrates in perspective a prior art emitter gun.

Figure 3 illustrates in cross section a detail of an embodiment of the invention.

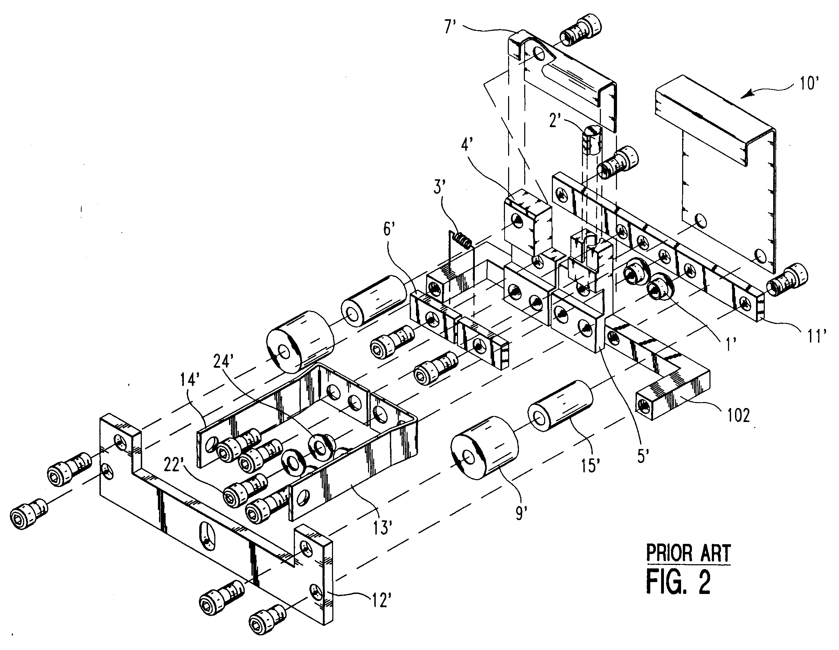

Referring now to the prior art electron gun in Figure 2, the operation of the device is described in which a current is passed through filament 3' to generate electrons in a conventional way. Filament 3' is held in position in cathode blocks 5' and 4' by clamps 6'. The electrons emitted from the filament are shaped by beam former 7', a shaped piece of metal that is in electrical contact with the left hand cathode clamp and is spaced apart from the right hand cathode clamp by spacing insulator 2'. Conventionally, a voltage of 12V AC is maintained between the two ends of filament 3' to heat it and an RF voltage of 10,000V at a nominal frequency of 13.56MHz is superimposed on the filament as it carries a current of 0 - 2A. Mounting bar 11' supports both the cathode blocks. The beam former 7' is maintained at the potential of the left side of filament, illustratively the RF voltage of 10,000V. The anode 10' is maintained at a nominal ground potential to accelerate the electrons emitted from the filament. The anode is supported by mounting bar 11' that is spaced from mounting bracket 102 by a pair of insulators 1' - that surround fastening screws. Unless otherwise specified, all materials and conductors in this assembly are stainless steel. The right hand filament bracket must be insulated from the mounting bar by flanges 1', which are prone to cracking and thus a source of shorts.

Those skilled in the art will readily appreciate that anode 10' and the beam former 7' are "cantilevered" off the respective mounting sources and, as they have a length of approximately 2 inches, there is potential for the 2 pieces of metal to come into direct contact or into close proximity. In such case, there is an evident potential for the formation of short circuits by deposition of particles that are present in the vacuum chamber.

The current for the filaments enters bus bars 13' and 14' from external leads not shown. Bus bars 13' and 14' are formed of molybdenum having a nominal thickness of 30 mils. Insulating flanges 24' serve to insulate the right hand bus bar, which is at the potential of the right hand filament from the screws 22' which are in direct mechanical contact with mounting bar 11' and thus at the potential of the left hand side of the filament. The emitter support member 12' is maintained at ground potential and supports both the mounting bar and the mounting bracket. Since the mounting bar is at a high voltage, ceramic insulating members 15' isolate it from the emitter bar. In order to prevent the formation of short circuits by deposition of material along the surface of insulators 15', a grounded metal cylindrical shield 9' encloses member 15' for part of its length.

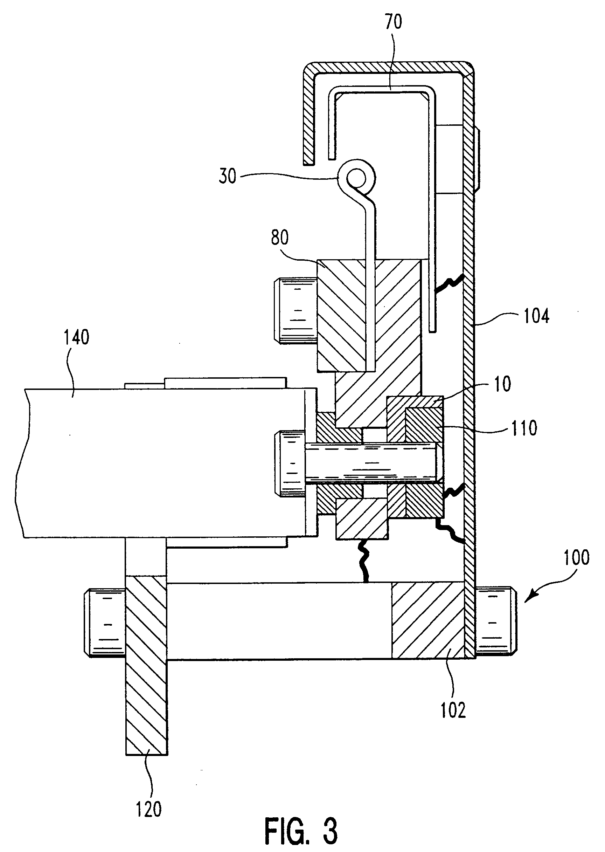

Referring now to Figure 3, there is shown a cross-section at the edge of the left cathode block showing the filament at the top and the close proximity of the anode and the beam forming plate. Jagged lines are drawn in most likely places for the lodging of shorting material.

One skilled in the art would be surprised to find that these are critical places because the anode covers and nearly encloses the beam former so that most of the beam former is blocked from deposition by particulates which are moving about nominally at random within the vacuum chamber. In addition, those skilled in the art will appreciate that the narrowest gaps are not susceptible to short circuits. The gap between beam former and the right cathode block is considerable narrower than the gap between the beam former and the anode, but it is not a source of trouble though it is just as exposed as the gaps that do present a problem.

The problem is especially acute in evaporator systems that use a number of different elements for deposition, illustratively Cr, Ni, Cu, Au, Ti, and Co. In this case, the worst element is nickel, presumably because it is magnetic and is more affected by the magnetic field that steers the electron beam than other elements are. The portions of the gun indicated by a heavy solid line in Figure 3 were flame sprayed with an 8 mil to 10 mil thick layer of alumina ceramic insulator in a conventional plasma spraying process. This area insulated was not the entire area that is susceptible to short circuits, thus saving on the cost of insulating all exposed surfaces. After the insulating was done, all shorts due to small flakes disappeared. Only larger flakes, those so large that they became wedged between electrodes, posed a problem. Such occurrences are rare, on the order of once a year.

It is surprising that short circuits were not eliminated by the insulation, as one would have expected. Inspection of disassembled emitter guns revealed tracks in the sensitive areas where small flakes had decomposed. What has happened is that the insulation has not blocked current flow, but has substituted for the former direct flow of electrons between electrodes ( i. e. an arc current ) an RF discharge current that burns off the flakes by the passage of the RF energy and associated eddy current or ohmic heating without breaking down to form an arc. In an RF discharge, an individual electron that happens to be between electrodes, whether as part of the residual gas in the vacuum chamber or as part of a particle, does not travel all the way between one electrode and another. Rather, it vibrates back and forth in a narrow region under the influence of the rapidly varying RF field. This heats the particles, which are all or mostly metal, much as metal is heated in a microwave oven without the passage of electrons over the whole distance. Thus, the flakes are removed in a non destructive manner that does not cause the insulator to break down. Insulators are now replaced in the refurbishing process at the end of the rated life of the emitter gun, so that the life of the emitter gun is now well in excess of the life of prior art guns.

In addition to the insulation, a number of mechanical changes were also made to the structure.

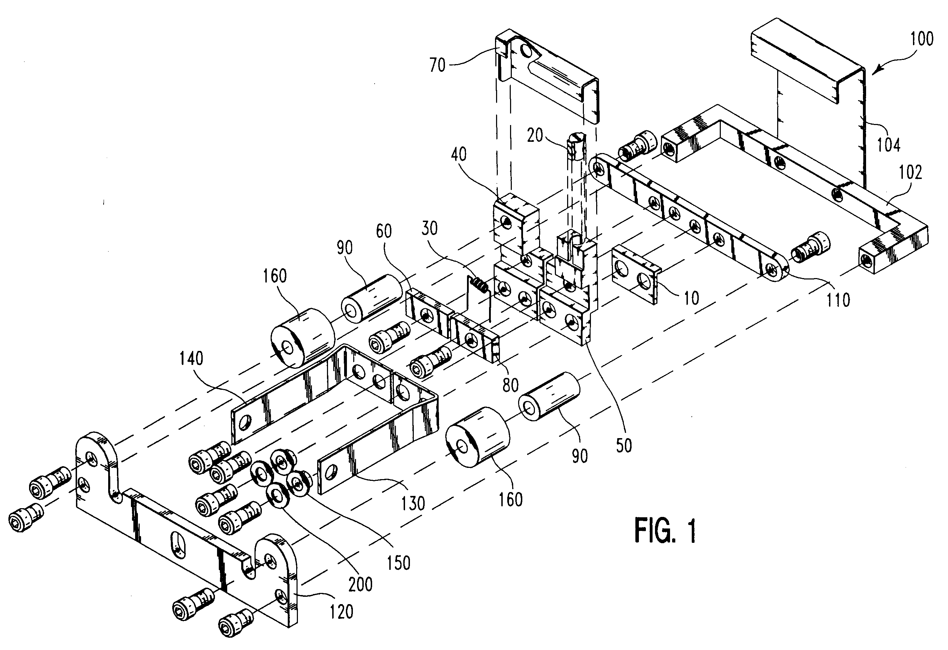

The structural changes may be illustrated by comparison of Figures 1 and 2. A substitute filament, available from Ulvac corporation offers an improved lifetime. Starting with the emitter support bar 120, it can be seen that a radius denoted with the letter A has been machined on both ears of the support bar and a cutout has been milled in the support bar to provide greater separation from the filament bus bars 130 and 140. These bars, which support only the electrical leads, were formerly made 0.030" thick. Surprisingly, they have been shown to be susceptible to the heat, even though they are spaced a considerable distance from the filament. The thickness of bus bars 130 and 140 were increased from .030 to .060 inches in order to provide additional rigidity.

The flanged insulators 150 were changed to increase the thickness of the flange from .060 to .090 inches to eliminate cracking of the insulators, a source of short circuits between the emitter mounting bar and the filament clamps. At the back of the mounting bracket, flanged insulators 1 have been replaced by a rectangular ceramic member 10 having a right angle, a nominal thickness of 0.062" and a nominal length of 0.750" that spreads the compressive force between the 8 filament block and mounting bar 110 better than the old flanged insulators 1'. Member 10 insulates the right hand cathode block from the mounting bar, the nominal potential difference being the 10,000V RF voltage.

The cylindrical insulators 90 are enclosed by a metal cylindrical shield 160 to prevent the deposition of particulates and the formation of short circuits along the surface of the insulator. The diameter of the insulator shield was reduced, not increased, from a nominal diameter of .625 inches to .500 inches thus reducing the gap between the insulator shield and the bus bars and nominally making it less susceptible to the formation of arcing and flakes between the bus bars and the insulator shield. The insulators themselves are available from Semiconductor Materials, Inc.

The legs of the mounting bracket 102 were increased by .030 inches to increase the gap between the anode 104 and the mounting bar 110 by the same amount. Beam former 70 (made of molybdenum) was modified by the elimination of a slot on the left side ( visible in Figure 2 ) and the substitution for the slot of a hole clearance for a 6-32 screw. The tab on the left side was lengthened to cover the area formerly covered by the slot, thus increasing the rigidity of the beam former and reducing its susceptibility to warping and lifting that tended to cause shorts. This reduced the possibility of short circuits between the beam former and the anode over the distance between them.

Mounting bar 110 was extended in length to move the high voltage spacing insulators 90 away from the filament blocks.

The anode (made of tantalum) was increased in vertical height by .030 inches to compensate for the larger gap between the anode and the mounting bar thus to give the same beam formation properties. The thickness of the anode was increased from .030 inches to .060 inches to provide increased resistance to warping.

The dimensions of the parts listed here are tightly constrained by the necessity of fitting in with existing parts and the necessity of the whole gun fitting in a confined space. Preferably, the increased distances or increased material thicknesses should be no more than 0.010 inches smaller than the dimensions given.

Those skilled in the art will readily appreciate that various modifications may be made to the embodiment of the invention illustrated and that some or all of the improvements illustrated may be used in different combinations, so that the following claims are not intended to be limited to the embodiment shown.

## Claims

1. An electron beam gun comprising:
a filament connected between first and second filament blocks for generating electrons by thermal emission, said first and second filament blocks providing mechanical support for said filament and extending upward past said filament along a z-first axis, terminating in first and second respective filament block tips;
first and second bus bars connected to said first and second filament blocks, respectively;
a beam former, formed from a piece of sheet stock and attached to said second filament block and extending horizontally from said second filament block toward and overlapping said first filament block along a x-second axis perpendicular to said first axis, said beam former being separated from said first filament block by an insulating spacer, thereby defining front and rear beam-former gaps along a y-third axis perpendicular to said first and second axes;
an anode, formed from a piece of sheet stock supported by an anode bracket and extending vertically from an initial position behind said beam former, then downwardly in front of said beam former, thereby defining front and rear beam former - anode gaps, characterized in that:
a front surface of said anode in said rear beam former-anode gap is insulated; and
a top surface of said anode bracket is insulated, whereby the formation of short circuits between elements in close proximity is reduced.

2. An electron beam gun according to claim 1, in which an elongated anode bracket extends along said first axis by a predetermined anode extension amount of greater than 0.020 inches, whereby said rear beam former - anode gap is increased; and
said anode extends vertically by a predetermined vertical anode extension amount of greater than 0.020 inches, whereby a vertical beam former-anode gap is increased by the same amount.

3. An electron beam gun according to claim 1 or 2, in which said anode is formed from tantalum at least 0.050 inches thick.

4. An electron beam gun according to any of claims 1 to 3, in which said insulator has a thickness sufficient to block a direct flow of electrons between adjacent electrodes, but permits the flow of RF energy through material deposited on one of said adjacent electrodes, whereby deposited material is removed by RF heating without the formation of a direct current path.

5. An electron beam gun according to any of the preceding claims, in which said first and second bus bars have a predetermined bus bar thickness of greater than 0.050 inches;
said first and second filament blocks are supported by a mounting bar that is attached to an emitter support bar by first and second high voltage spacing insulators, said emitter support bar being disposed below said first and second bus bars and having a recess formed therein in alignment with said first and second bus bars, whereby a vertical spacing distance between said first and second bus bars and said emitter support bar is reduced.
